(19) **Europäisches Patentamt / European Patent Office / Office européen des brevets**

(11) **EP 3 358 606 B1**

(12) **EUROPEAN PATENT SPECIFICATION**

(45) Date of publication and mention
of the grant of the patent:
**26.02.2025 Bulletin 2025/09**

(21) Application number: **16851304.2**

(22) Date of filing: **21.09.2016**

(51) International Patent Classification (IPC):
$H01L\ 21/683$ $^{(2006.01)}$   $H01L\ 23/00$ $^{(2006.01)}$
$C08K\ 3/08$ $^{(2006.01)}$   $C08K\ 3/22$ $^{(2006.01)}$
$C09J\ 7/10$ $^{(2018.01)}$   $C09J\ 9/00$ $^{(2006.01)}$
$C09J\ 11/04$ $^{(2006.01)}$   $C09J\ 201/00$ $^{(2006.01)}$

(52) Cooperative Patent Classification (CPC):
(C-Sets available)
H01L 24/29; C09J 7/10; C09J 9/00; C09J 11/04;
C09J 201/00; H01L 21/6836; H01L 24/27;
H01L 24/83; H01L 24/85; H01L 24/92; B22F 1/054;
B22F 1/102; B22F 1/107; C08K 2003/0806;
C08K 2003/085;   (Cont.)

(86) International application number:
**PCT/JP2016/077838**

(87) International publication number:
**WO 2017/057130 (06.04.2017 Gazette 2017/14)**

(54) **THERMAL BONDING SHEET, AND THERMAL BONDING SHEET WITH DICING TAPE**

THERMISCHE VERBINDUNGSFOLIE UND THERMISCHE VERBINDUNGSFOLIE MIT SÄGEFOLIE

FEUILLE DE LIAISON THERMIQUE, ET FEUILLE DE LIAISON THERMIQUE DOTÉ DE RUBAN DE DÉCOUPAGE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.09.2015   JP 2015194243**

(43) Date of publication of application:
**08.08.2018   Bulletin 2018/32**

(73) Proprietor: **Nitto Denko Corporation**
**Ibaraki-shi, Osaka 567-8680 (JP)**

(72) Inventors:
• **SUGO, Yuki**
**Ibaraki-shi**
**Osaka 567-8680 (JP)**
• **KAMAKURA, Nao**
**Ibaraki-shi**
**Osaka 567-8680 (JP)**

(74) Representative: **Grünecker Patent- und Rechtsanwälte PartG mbB**
**Leopoldstraße 4**
**80802 München (DE)**

(56) References cited:
EP-A1- 3 059 740   EP-A1- 3 239 258
WO-A1-2015/060346   JP-A- 2010 254 763
JP-A- 2015 079 650   JP-A- 2015 079 650
JP-A- H11 232 417   US-A1- 2014 131 898

• JULIAN KAHLER ET AL: "Pick-and-Place Silver Sintering Die Attach of Small-Area Chips", IEEE TRANSACTIONS ON COMPONENTS, PACKAGING AND MANUFACTURING TECHNOLOGY, IEEE, USA, vol. 2, no. 2, February 2012 (2012-02-01), pages 199 - 207, XP011402107, ISSN: 2156-3950, DOI: 10.1109/ TCPMT.2011.2170571

**EP 3 358 606 B1**

**(Cont. next page)**

• KIM S SIOW ED - BATTEZZATI LIVIO ET AL: "Mechanical properties of nano-silver joints as die attach materials", JOURNAL OF ALLOYS AND COMPOUNDS, ELSEVIER SEQUOIA, LAUSANNE, CH, vol. 514, 28 October 2011 (2011-10-28), pages 6 - 19, XP028347578, ISSN: 0925-8388, [retrieved on 20111107], DOI: 10.1016/J.JALLCOM.2011.10.092

(52) Cooperative Patent Classification (CPC): (Cont.)
C08K 2003/2248; C08K 2003/2286; C09J 2203/326;
C09J 2301/304; C09J 2301/408; H01L 24/05;
H01L 24/32; H01L 24/45; H01L 24/48; H01L 24/94;
H01L 2221/68327; H01L 2224/04026;
H01L 2224/05073; H01L 2224/05166;
H01L 2224/05639; H01L 2224/27003;
H01L 2224/271; H01L 2224/27436;
H01L 2224/29294; H01L 2224/29339;
H01L 2224/29344; H01L 2224/29347;
H01L 2224/29387; H01L 2224/2939;
H01L 2224/29499; H01L 2224/32225;
H01L 2224/32245; H01L 2224/45124;
H01L 2224/45144; H01L 2224/45147;
H01L 2224/48091; H01L 2224/48227;
H01L 2224/73265; H01L 2224/83203;
H01L 2224/83444; H01L 2224/83447;
H01L 2224/8346; H01L 2224/8384;
H01L 2224/85203; H01L 2224/85207;
H01L 2224/92; H01L 2224/92247; H01L 2224/94;
H01L 2924/13055; H01L 2924/13091;
H01L 2924/15311; H01L 2924/15747;
H01L 2924/1576; H01L 2924/181

C-Sets
H01L 2224/05073, H01L 2224/05639,
H01L 2224/05166;

H01L 2224/05166, H01L 2924/00014;
H01L 2224/05639, H01L 2924/00014;
H01L 2224/29294, H01L 2924/00012;
H01L 2224/29339, H01L 2924/00014;
H01L 2224/29344, H01L 2924/00014;
H01L 2224/29347, H01L 2924/00014;
H01L 2224/29387, H01L 2924/0541,
H01L 2924/01029;
H01L 2224/29387, H01L 2924/0541,
H01L 2924/01047;
H01L 2224/45124, H01L 2924/00014;
H01L 2224/45144, H01L 2924/00014;
H01L 2224/45147, H01L 2924/00014;
H01L 2224/48091, H01L 2924/00014;
H01L 2224/73265, H01L 2224/32225,
H01L 2224/48227, H01L 2924/00;
H01L 2224/83203, H01L 2924/00012;
H01L 2224/83444, H01L 2924/00014;
H01L 2224/92, H01L 2224/27003,
H01L 2224/27436, H01L 21/78, H01L 2221/68381,
H01L 2224/83;
H01L 2224/92247, H01L 2224/73265,
H01L 2224/32225, H01L 2224/48227,
H01L 2924/00;
H01L 2224/94, H01L 2224/27;
H01L 2924/13055, H01L 2924/00;
H01L 2924/13091, H01L 2924/00;
H01L 2924/15311, H01L 2224/73265,
H01L 2224/32225, H01L 2224/48227,
H01L 2924/00;
H01L 2924/15747, H01L 2924/00014;
H01L 2924/1576, H01L 2924/01028;
H01L 2924/181, H01L 2924/00012

**Description**

TECHNICAL FIELD

The present invention relates to a thermal bonding sheet and a thermal bonding sheet with dicing tape.

BACKGROUND ART

In production of semiconductor devices, the method of bonding a semiconductor element to an adherend such as a metallic lead frame (so-called bonding method) has been transited to methods by a solder and a resin paste from the conventional gold-silicon eutectic crystal that has been initially used. At present, a conductive resin paste is sometimes used.

However, in the method of using a conductive resin paste, deterioration in conductivity and nonuniformity in thickness of the paste due to generation of voids, and staining of the pad due to extrusion and the like can occur.

On the other hand, recently, power semiconductor devices that control or supply electric power have remarkably spread. A power semiconductor device has high calorific power because an electrical current usually flows through the device. Therefore, it is desired for a conductive adhesive that is used in a power semiconductor device to have high heat radiation property and low electric resistivity.

A power semiconductor device is required to operate at high speed with low loss. Conventionally, in a power semiconductor device, a semiconductor using Si such as IGBT (Insulated Gate Bipolar Transistor) or MOSFET (Metal-Oxide-Semiconductor Field-Effect Transistor) has been used. Recently, those using a semiconductor such as SiC or GaN have been developed and expected to extend in the future.

A semiconductor using SiC or GaN is featured by a large band gap, and high dielectric breakdown electric field, and is able to operate with low loss, at high speed and high temperature. Operation at high temperature is a merit in automobiles, small power converters and the like that operate in severe thermal environments. Since a semiconductor device having an application in a severe heat environment is assumed to operate at high temperature around 250°C, problems arise in heat characteristics and reliability with a solder or a conductive adhesive that is a conventional bonding/adhering material. In light of this, a paste material containing sintered metal particles has been proposed (see, Patent Document 1, for example). The paste material containing sintered metal particles contain nano-sized to micro-sized metal particles, and these metal particles melt at a temperature that is lower than the normal melting point due to the nano-size effect and sintering between particles progresses.

Non-patent Document 2 provides a review of thermal bonding sheets comprising a precursor layer that is to become a sintered layer by heating. The precursor layer contains metal particles dispersed in a suitable dispersant as well as a binder, including compounds that are thermally decomposable and solid at 23°C.

PRIOR ART DOCUMENTS

Patent Document 1: JP-A-2014-111800

Non-patent Document 2: Kim S. Siow, "Mechanical propertiers of nano-silver joints as die attach materials", Journal of Alloys and Compounds, . 514, 28 October 2011, pages 6-19

SUMMARY OF THE INVENTION

PROBLEMS TO BE SOLVED BY THE INVENTION

However, since the paste material containing sintered metal particles is in a paste state as literally shown, the thickness is nonuniform as is the case with a conductive resin paste, resulting that bonding irregularity occurs, and in particular, the bonding reliability at high temperatures can deteriorate.

The present invention was devised in light of the above problems, and it is an object of the present invention to provide a thermal bonding sheet capable of preventing bonding irregularity by uniform thickness, and imparting the bonding reliability at high temperatures, and a thermal bonding sheet with dicing tape having the thermal bonding sheet.

MEANS FOR SOLVING THE PROBLEMS

As a result of diligent efforts to solve the aforementioned conventional problems,

the present inventors found that the problems can be solved by a
thermal bonding sheet according to the present invention.

To be more specific, a thermal bonding sheet according to the present invention

has a precursor layer that is to become a sintered layer by heating, and
the precursor layer has an average thickness of 5 $\mu$m to 200 $\mu$m, and
the precursor layer has a maximum thickness and a minimum thickness falling
within a range of $\pm$20% of the average thickness.

Since the thermal bonding sheet has a precursor layer that is to become a

sintered layer by heating, and a sintered layer is obtained by a heating treatment,
high bonding reliability is achieved even when the thermal bonding sheet is used for bonding a power semiconductor device or the like that operates in a high temperature environment. Also, since the precursor layer has an average thickness of 5 $\mu$m to 200 $\mu$m, and the precursor layer has a maximum thickness and a minimum thickness falling within a range of $\pm$20% of the average thickness, the thickness uniformity is satisfied at a high level, the bonding irregularity is prevented, and the high temperature reliability can be improved.

The thermal bonding sheet according to an embodiment of the present invention has a precursor layer that is to become a sintered layer by heating, and

the precursor layer has an average thickness of 5 $\mu$m to 200 $\mu$m and a surface roughness Sa of 2 $\mu$m or less measured in a field of view of 200 $\mu$m $\times$ 200 $\mu$m by a confocal microscope.

Since the thermal bonding sheet has a precursor layer that is to become a

sintered layer by heating, and a sintered layer is obtained by a heating treatment,
high bonding reliability is achieved even when the thermal bonding sheet is used
for bonding a power semiconductor device or the like that operates in a high
temperature environment. The precursor layer has an average thickness of 5 $\mu$m
to 200 $\mu$m, and a surface roughness Sa of 2 $\mu$m or less measured in a field of
view of 200 $\mu$m $\times$ 200 $\mu$m by a confocal microscope. As a result, unevenness in the thickness direction is controlled, and the thickness uniformity is satisfied at a high level, so that the bonding irregularity is prevented and high temperature bonding reliability can be improved.

Regarding the thermal bonding sheet, when differential thermogravimetric measurement is carried out at a temperature rising speed of 10°C/min from 23°C to 400°C in an ambient atmosphere, the weight reduction rate $\Delta$W obtained by the following formula is preferably -9% to -3%.

$$\Delta W(\%) = \{(W_{400} - W_{23})/W_{23}\} \times 100$$

(wherein, $W_{23}$ represents weight of the thermal bonding sheet at 23°C, and $W_{400}$ represents weight of the thermal bonding sheet at 400°C.)

If a large amount of organic component or the like remains at the time of sintering the precursor layer, sintering of the precursor layer is inhibited, and the strength or the heat characteristics of the obtainable sintered layer can be deteriorated. Since the weight reduction rate falls within the above range in the thermal bonding sheet, the organic component, or the solvent or the like that can be contained in the thermal bonding sheet is sufficiently removed by the heating at the time of converting the precursor layer to the sintered layer. This allows sintering of the precursor layer to sufficient progress and improves the bonding reliability. When the weight reduction rate falls within the above range, the thickness uniformity is excellent.

In the above constitution,
the precursor layer contains a thermally decomposable binder that is solid at 23°C.

Since the precursor layer contains a thermally decomposable binder that is solid at 23°C, the sheet form is easy to be maintained before the thermal bonding step. Also, it is easy to be thermally decomposed in the thermal bonding step.

In the above constitution,

the precursor layer contains metallic fine particles, and
the metallic fine particles are
at least one selected from the group consisting of
silver, copper, silver oxide and copper oxide.

Since the precursor layer contains metallic fine particles, and the metallic fine particles are at least one selected from the group consisting of silver, copper, silver oxide and copper oxide, the thermal bonding can be achieved more favorably.

A thermal bonding sheet with dicing tape according to the present invention has:

> a dicing tape, and
> the thermal bonding sheet laminated on the dicing tape.

According to the thermal bonding sheet with dicing tape, since it is unitary with the dicing tape, the step of bonding with the dicing tape can be omitted. Since the thermal bonding sheet is provided, it is possible to prevent the bonding irregularity by the thickness uniformity, and it is possible to obtain excellent bonding reliability. Since the thermal bonding sheet having the precursor layer is provided, the sintered layer obtainable by heating the precursor layer is firm, and the high temperature bonding reliability can be improved.

BRIEF DESCRIPTION OF THE DRAWINGS

> Fig. 1 is a cross-sectional schematic view showing a thermal bonding sheet with dicing tape according to one embodiment of the present invention.
> Fig. 2 is a cross-sectional schematic view showing a thermal bonding sheet with dicing tape according to other embodiment of the present invention.
> Fig. 3 is a cross-sectional schematic view showing a thermal bonding sheet with both-side separators.
> Fig. 4 is a cross-sectional schematic view for illustrating a method of manufacturing a semiconductor device according to one embodiment of the present invention.
> Fig. 5 is an observed image by an ultrasonic imaging device for evaluating bonding in Example 1 and Comparative Example 1.

MODE FOR CARRYING OUT THE INVENTION

Hereinafter, embodiments of the thermal bonding sheet and the thermal bonding sheet with dicing tape of the present invention are described by referring to attached drawings. In part or whole of drawings, the part that is unnecessary for description is omitted, and some part is shown while it is scaled up or down for facilitating the description. The term indicating the positional relationship, such as up or down is merely used for facilitating the description and is not intended to limit the constitution of the present invention.

<<First embodiment>>

(Thermal bonding sheet with dicing tape)

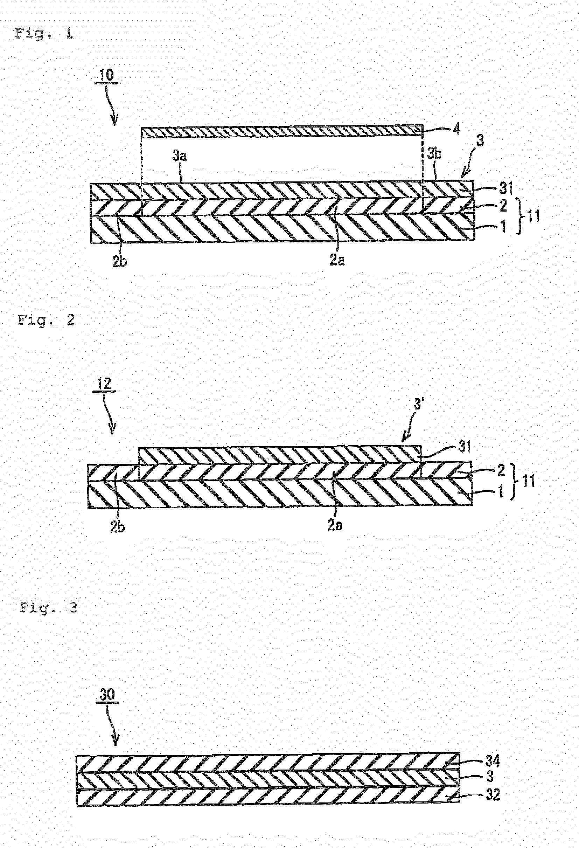

One exemplary thermal bonding sheet according to the present embodiment is in a state that the dicing tape is not bonded in the thermal bonding sheet with dicing tape as will be described below. Therefore, in the following, description is made for the thermal bonding sheet with dicing tape, and the thermal bonding sheet will be described in the description, Fig. 1 is a cross-sectional schematic view showing a thermal bonding sheet with dicing tape according to one embodiment of the present invention. Fig. 2 is a cross-sectional schematic view showing other thermal bonding sheet with dicing tape according to other embodiment of the present invention.

As shown in Fig. 1, a thermal bonding sheet with dicing tape 10 has such a structure that a thermal bonding sheet 3 is laminated on a dicing tape 11. The dicing tape 11 is structured by laminating a pressure-sensitive adhesive layer 2 on a base material 1, and the thermal bonding sheet 3 is disposed on the pressure-sensitive adhesive layer 2. Also, the thermal bonding sheet with dicing tape of the present invention may have such a structure that a thermal bonding sheet 3' is formed only in a work attaching part as in a thermal bonding sheet with dicing tape 12 shown in Fig. 2.

(Thermal bonding sheet)

The thermal bonding sheet 3, 3' is in a sheet form. The sheet form rather than the paste form can provide excellent thickness uniformity and handleability.

The thermal bonding sheet 3, 3' according to the present embodiment includes a precursor layer 31 that is to become a sintered layer by heating. In the present embodiment, description is made for the case where the thermal bonding sheet contains only one layer of a precursor layer that is to become a sintered layer by heating, however, the present invention is not limited to this case. The precursor layer that is to become a sintered layer by heating may have such a structure that a plurality of precursor layers are laminated.

Also, in the present embodiment, description is made for the case where the thermal bonding sheet includes a precursor layer that is to become a sintered layer by heating, however, the present invention is not limited to this case. The thermal bonding sheet of the present invention may include two or more layers. For example, the thermal bonding sheet may have such a structure that a precursor layer that is to become a sintered layer by heating, and other layer (layer that is not to become a sintered layer by heating) are laminated.

That is, it is only required that the thermal bonding sheet according to the present invention has at least a precursor layer that is to become a sintered layer by heating, and other constitution is not particularly limited.

(Precursor layer that is to become sintered layer by heating)

The precursor layer 31 that is to become a sintered layer by heating (hereinafter, also simply referred to as "precursor layer 31") has an average thickness of 5 $\mu$m to 200 $\mu$m, preferably 10 $\mu$m to 150 $\mu$m, more preferably 15 $\mu$m to 100 $\mu$m. By setting the average thickness of the precursor layer 31 before heating within the above range, it is possible to maintain the sheet form and secure the thickness uniformity.

The maximum thickness and the minimum thickness of the precursor layer 31 fall within the range of $\pm 20\%$, preferably within the range of $\pm 17\%$, more preferably within the range of $\pm 15\%$ of the average thickness. By setting the maximum thickness and the minimum thickness of the precursor layer to fall within a predetermined range with respect to the average thickness, the thickness uniformity is satisfied at a high level, the bonding irregularity is prevented, and the high temperature reliability can be improved. The average thickness, the maximum thickness, and the minimum thickness can be determined in the method described in Examples.

The precursor layer 31 has a tensile modulus obtained by the following tensile testing method of preferably 10 MPa to 3000 MPa, more preferably 12 MPa to 2900 MPa, further preferably 15 MPa to 2500 MPa.

Tensile testing method:

> (1) As a test sample, a thermal bonding sheet (thermal bonding sheet for tensile test) having a thickness of 200 $\mu$m, a width of 10 mm, and a length of 40 mm is prepared,
> (2) a tensile test is conducted with a distance between chucks of 10 mm, a tensile speed of 50 mm/min, at 23°C, and
> (3) the inclination of the linear part of the obtained stress-strain chart is determined as a tensile modulus.

When the tensile modulus of the precursor layer 31 is 10 MPa or more, it is possible to further prevent the material forming the thermal bonding sheet from protruding or climbing up on the chip surface at the time of die attachment. When the tensile modulus is 3000 MPa or less, it is possible to fix the semiconductor wafer, for example, at the time of dicing.

The precursor layer 31 has a carbon concentration obtained by the energy dispersive X-ray analysis after temperature rise from 23°C to 400°C at a temperature rising speed of 10°C/min in an ambient atmosphere of preferably 15% by weight or less, more preferably 12% by weight or less, further preferably 10% by weight or less. When the carbon concentration is 15% by weight or less, almost no organic matter exists in the precursor layer 31 after temperature rise to 400°C. As a result, after the thermal bonding step, excellent heat resistance, and high reliability and heat characteristics even in high temperature environment are achieved.

The precursor layer 31 shows a peak observed in a differential thermal analysis from 23°C to 500°C at a temperature rising speed of 10°C/min in an ambient atmosphere existing preferably in the range of 150 to 350°C, more preferably in the range of 170 to 320°C, further preferably in the range of 180 to 310°C. When the peak exists in the range of 150 to 350°C, it is deemed that the organic matter (such as a resin component forming the precursor layer 31) is thermally decomposed in this temperature range. As a result, the heat resistance after the thermal bonding step is more excellent.

The precursor layer 31 contains 60 to 98% by weight of metallic fine particles, relative to the entire precursor layer 31. The content of the metallic fine particles is preferably within the range of 65 to 97% by weight, further preferably within the range of 70 to 95% by weight. When the metallic fine particles are contained in the range of 60 to 98% by weight, it is possible to bond two or more matters (for example, semiconductor chip and lead frame) by sintering or melting the metallic fine particles.

Examples of the metallic fine particles include sintering metallic particles.

As the sintering metallic particles, an aggregate of metallic particles can be favorably used. Examples of the metallic fine particles include fine particles of metal. Examples of the metal include gold, silver, copper, silver oxide, and copper oxide. Among these, at least one selected from the group consisting of silver, copper, silver oxide, and copper oxide is used according to the present invention

. When the metallic fine particles are at least one selected from the group consisting of silver, copper, silver oxide and copper oxide, the thermal bonding can be achieved more favorably.

The average particle size of the sintering metallic particles is 0.0005 $\mu$m or more, preferably 0.001 $\mu$m or more. Examples of the lower limit of the average particle size include 0.01 $\mu$m, 0.05 $\mu$m, and 0.1 $\mu$m. On the other hand, the average particle size of the sintering metallic particles is 30 $\mu$m or less, preferably 25 $\mu$m or less. Examples of the upper limit of the average particle size include 20 $\mu$m, 15 $\mu$m, 10 $\mu$m, and 5 $\mu$m.

The average particle size of the sintering metallic particles is determined in the following method. To be more specific, the sintering metallic particles are observed by SEM (scanning electron microscope) and an average particle size is determined. The SEM observation is preferably conducted with a 5000-fold magnification for the sintering metallic particles of micro size, and with a 50000-fold magnification for the submicro-sized sintering metallic particles, and with a 300000-fold magnification for the nano-sized sintering metallic particles.

The shape of the sintering metallic particles is not particularly limited, and is, for example, globular, bar-like, scaly, or indefinite.

The precursor layer 31 contains a low-boiling-point binder. The low-boiling-point binder is used for facilitating the handling of the metallic fine particles. Concretely, it can be used as a metallic fine particles-containing paste in which the metallic fine particles are dispersed in the low-boiling-point binder.

Additionally, it is preferred to contain the low-boiling-point binder also for adjusting the precursor layer of the sintered layer to have a desired mechanical property.

The low-boiling-point binder is liquid at 23°C. In the present description, "liquid" includes semi-liquid. Concretely, "liquid" has a viscosity at 23°C, determined by viscosity measurement using a dynamic viscoelasticity measuring device (rheometer) in the following condition of 100,000 Pa·sec or less.

<Viscosity measuring condition>

Rheometer: "MER III" available from Thermo SCIENTFIC
Tool: Parallel plate 20 mm$\Phi$
Gap: 100 $\mu$m
Shear rate: 1/sec

The low-boiling-point binder is selected from monohydric or polyhydric alcohols such as pentanol, hexanol, heptanol, octanol,

1-decanol, ethylene glycol, diethylene glycol, propylene glycol, butylene glycol,
$\alpha$-terpineol, 1,6-hexanediol, and isobornyl cyclohexanol (MTPH);
ethers such as ethylene glycol butyl ether, ethylene glycol phenyl ether,
diethylene glycol methyl ether, diethylene glycol ethyl ether, diethylene glycol
butyl ether, diethylene glycol isobutyl ether, diethylene glycol hexyl ether,
triethylene glycol methyl ether, diethylene glycol dimethyl ether, diethylene glycol
diethyl ether, diethylene glycol dibutyl ether, diethylene glycol butylmethyl ether,
diethylene glycol isopropylmethyl ether, triethylene glycol dimethyl ether,
triethylene glycol butylmethyl ether, propylene glycol propyl ether, dipropylene
glycol methyl ether, dipropylene glycol ethyl ether, dipropylene glycol propyl
ether, dipropylene glycol butyl ether, dipropylene glycol dimethyl
ether, tripropylene glycol methyl ether, and tripropylene glycol dimethyl ether;
and ethylene glycol ethyl ether acetate, ethylene glycol butyl ether acetate, diethylene glycol ethyl ether acetate,
diethylene glycol butyl ether acetate, and dipropylene glycol methyl ether acetate (DPMA). Combinations of two or
more of these may be used. Among these, a combination of two of these having different boiling-point points is
preferably used. Use of a combination of two of these having different boiling-point points results in excellent retention
of the sheet form.

The precursor layer 31 contains a thermally decomposable binder that is solid at 23°C. When the thermally decomposable binder is contained, the sheet form is easy to be maintained before the thermal bonding step. Also it is easy to be thermally decomposed in the thermal bonding step.

In this description, "solid" has a viscosity at 23°C, determined by viscosity measurement using a rheometer of more than 100,000 Pa·s.

In the present description, "thermally decomposable binder" means a binder that can be thermally decomposed in the thermal bonding step. It is preferred that the thermally decomposable binder little remains in the sintered layer (precursor layer 31 after heating) after the thermal bonding step. Examples of the thermally decomposable binder include materials having a carbon concentration obtained by the energy dispersive X-ray analysis after temperature rise from 23°C to 400°C at a temperature rising speed of 10°C/min in an ambient atmosphere of preferably 15% by weight or less even when it is contained in the precursor layer 31. For example, by employing a material that is easier to thermally decompose as the thermally decomposable binder, it is possible to make the thermally decomposable binder little remain in the sintered layer (precursor layer 31 after heating) after the thermal bonding step even if the content of the thermally decomposable binder is relatively large.

Examples of thermally decomposable binders include polycarbonate, acryl resin, ethyl cellulose, and polyvinyl alcohol. According to the present invention, the thermally decomposable binder is selected from the group consisting of acryl resin or polycarbonate.

These materials can be used solely or in combination

. Among these, polycarbonate is preferred from the view point of high thermal decomposability.

While the polycarbonate is not particularly limited as far as it can thermally decompose in the thermal bonding step, examples of the polycarbonate include aliphatic polycarbonates that do not contain an aromatic compound (for example, benzene ring) between carbonate ester groups (-O-CO-O-) of the main chain, and are composed of an aliphatic chain, and aromatic polycarbonates that contain an aromatic compound between carbonate ester groups (-O-CO-O-) of the main chain. Among these, aliphatic polycarbonates are preferred.

Examples of the aliphatic polycarbonates include polyethylene carbonate, and polypropylene carbonate. Among these, polypropylene carbonate is preferred from the view point of solubility in an organic solvent in preparation of vanish for forming a sheet.

Examples of the organic polycarbonate include those containing a bisphenol A structure in the main chain.

The polycarbonate has a weight average molecular weight of preferably in the range of 10,000 to 1,000,000. The weight average molecular weight is a value that is measured by GPC (gel permeation chromatography) and calculated by conversion by polystyrene.

Examples of the acryl resin include polymers (acryl copolymers) composed of one or two or more esters of acrylic acid or methacrylic acid having a straight-chain or branched alkyl group having 30 or less carbons, particularly 4 to 18 carbons as far as they can thermally decompose in the thermal bonding step. Examples of the alkyl group include a methyl group, an ethyl group, a propyl group, an isopropyl group, an n-butyl group, a t-butyl group, an isobutyl group, an amyl group, an isoamyl group, a hexyl group, a heptyl group, a cyclohexyl group, a 2-ethylhexyl group, an octyl group, an isooctyl group, a nonyl group, an isononyl group, a decyl group, an isodecyl group, a undecyl group, a lauryl group, a tridecyl group, a tetradecyl group, a stearyl group, an octadecyl group, or a dodecyl group.

Examples of other monomer that forms a polymer (acryl copolymer) include, but are not limited to, carboxyl group-containing monomers such as acrylic acid, methacrylic acid, carboxyethyl acrylate, carboxypentyl acrylate, itaconic acid, maleic acid, fumaric acid or crotonic acid, acid anhydride monomers such as maleic anhydride or itaconic anhydride, hydroxyl group-containing monomers such as (meth)acrylate 2-hydroxyethyl (meth)acrylate, 2-hydroxypropyl (meth) acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate or (4-hydroxymethylcyclohexyl)-methylacrylate, sulfonic group-containing monomers such as styrenesulfonic acid, allylsulfonic acid, 2-(meth)acrylamide-2-methylpropanesulfonic acid, (meth) acrylamide propanesulfonic acid, sulfopropyl (meth)acrylate or (meth)acryloyloxynaphthalenesulfonic acid, or phosphoric group-containing monomers such as 2-hydroxyethylacryloylphosphate.

Among the acryl resins, those having a weight average molecular weight of 10000 to 1000000 are more preferred, and those having a weight average molecular weight of 30000 to 700000 are further preferred. This is because those satisfying the numerical ranges described above are excellent in adhesion before the thermal bonding step, and in thermal decomposition during the thermal bonding step. The weight average molecular weight is a value that is measured by GPC (gel permeation chromatography) and calculated by conversion by polystyrene.

Among the acryl resin, acryl resins that thermally decompose at 200°C to 400°C are preferred.

Regarding the thermal bonding sheet 3, 3', when differential thermogravimetric measurement is carried out at a temperature rising speed of 10°C/min from 23°C to 400°C in an ambient atmosphere, a weight reduction rate $\Delta W$ obtained by the following formula is preferably -9% to -3%, more preferably -8% to -3.1%.

$$\Delta W(\%) = \{(W_{400} - W_{23})/W_{23}\} \times 100$$

(wherein, $W_{23}$ represents weight of the thermal bonding sheet at 23°C, and $W_{400}$ represents weight of the thermal bonding sheet at 400°C.)

If a large amount of organic component or the like remains at the time of sintering the precursor layer 31, sintering of the precursor layer 31 is inhibited, and the strength or the heat characteristics of the obtainable sintered layer can be deteriorated. Since the weight reduction rate falls within the above range in the thermal bonding sheet 3, 3', the organic component (for example, a low-boiling-point binder, a thermally decomposable binder and the like as described above), the solvent or the like that can be contained in the thermal bonding sheet are sufficiently removed by the heating at the time of converting the precursor layer to the sintered layer. This allows sintering of the precursor layer to sufficient progress and improves the bonding reliability. When the weight reduction rate falls within the above range, the thickness uniformity is excellent.

The precursor layer 31 may contain, for example, a plasticizer, besides the aforementioned components as appropriate.

The thermal bonding sheets 3, 3' can be produced in an ordinary method. For example, a vanish containing aforementioned components for forming the precursor layer 31 is prepared, and the vanish is applied on a base separator to have a predetermined thickness to form an applied film, and then the applied film is dried to produce the thermal bonding sheets 3, 3'.

Preferred examples of the solvent used for the vanish include, but are not limited to, organic solvents and alcohol solvents capable of uniformly dissolving, kneading or dispersing the components. Examples of the organic solvents include ketone-based solvents such as dimethylformamide, dimethylacetamide, N-methylpyrrolidone, acetone, methylethylketone and cyclohexanone, toluene, and xylene. Examples of the alcohol solvents include ethylene glycol, diethylene glycol, 1,2-propanediol, 1,3-propanediol, 1,2-butanediol, 1,3-butanediol, 1,4-butanediol, 2-butene-1,4-diol, 1,2,6-hexanetriol, glycerin, octanediol, 2-methyl-2,4-pentanediol, and terpineol.

The applying method is not particularly limited. Examples of the method for applying a solvent include a die coater, a gravure coater, a roll coater, a reverse coater, a comma coater, a pipe doctor coater, and screen printing. Among these, a die coater is preferred from the view point of high uniformity of application thickness. The drying condition of the applied film is not particularly limited, and for example, the applied film can be dried, for example, at a drying temperature of 70 to 160°C for a drying time of 1 to 5 minutes. Even after drying the applied film, the solvent fails to entirely vaporize and remains in the coating film depending on the solvent.

When the precursor layer 31 contains the low-boiling-point binder, the low-boiling binder-point can partly volatilize depending on the drying condition. Therefore, the ratio of the components constituting the precursor layer 31 varies depending on the drying condition. For example, for the precursor layer 31 that is formed of the same vanish, the higher the drying temperature, and the longer the drying time, the larger the content of the metallic fine particles in the entire precursor layer 31 and the content of the thermally decomposable binder become. Therefore, it is preferred to set the drying condition so that the contents of the metallic fine particles and the thermally decomposable binder in the precursor layer 31 are desired amounts.

As the base separator, a plastic film or paper having a surface coated with a release agent such as polyethylene terephthalate (PET), polyethylene, polypropylene, a fluorine-based release agent, a long-chain alkyl acrylate-based release agent can be used.

As the manufacturing method of the thermal bonding sheet 3, 3', for example, a method of mixing the components, and press-molding the obtained mixture to produce the thermal bonding sheet 3, 3' is also preferred. Examples of the mixer include a planetary mixer.

(Dicing tape)

The dicing tape 11 is formed by laminating the pressure-sensitive adhesive layer 2 on the base material 1.

The base material 1 is a base for the strength of the thermal bonding sheet with dicing tape 10, 12, and is preferably ultraviolet transmissive. Examples of the base material 1 include polyolefin such as low-density polyethylene, straight chain polyethylene, intermediate-density polyethylene, high-density polyethylene, very low-density polyethylene, random copolymer polypropylene, block copolymer polypropylene, homopolypropylene, polybutene, and polymethylpentene; an ethylene-vinylacetate copolymer; an ionomer resin; an ethylene(meth)acrylic acid copolymer; an ethylene(meth)acrylic acid ester (random or alternating) copolymer; an ethylene-butene copolymer; an ethylene-hexene copolymer; polyurethane; polyester such as polyethyleneterephthalate and polyethylenenaphthalate; polycarbonate; polyetheretherketone; polyetherimide; polyamide; whole aromatic polyamides; polyphenylsulfide; aramid (paper); glass; glass cloth; a fluorine resin; polyvinyl chloride; polyvinylidene chloride; a cellulose resin; a silicone resin; metal (foil); and paper.

Further, the material of the base material 1 includes a polymer such as a cross-linked body of the above resins. The above plastic film may be also used unstreched, or may be also used on which a monoaxial or a biaxial stretching treatment is performed depending on necessity. According to resin sheets in which heat shrinkable properties are given by the stretching treatment, etc., the adhesive area of the pressure sensitive adhesive layer 2 and the thermal bonding sheet 3, 3' is reduced by thermally shrinking the base material 1 after dicing, and the recovery of the semiconductor chips can be facilitated.

A known surface treatment such as a chemical or physical treatment such as a chromate treatment, ozone exposure, flame exposure, high voltage electric exposure, and an ionized radiation treatment, and a coating treatment by an undercoating agent (for example, a tacky substance described later) can be performed on the surface of the base material 1 in order to improve adhesiveness, holding properties, etc. with the adjacent layer.

The thickness of the base material 1 can be appropriately decided without limitation particularly. However, it is generally about 5 to 200 μm.

Examples of the pressure-sensitive adhesive layer 2 include, but are not limited to, common pressure-sensitive adhesives such as an acryl-based pressure-sensitive adhesive or a rubber-based pressure-sensitive adhesive. An acrylic pressure-sensitive adhesive having an acrylic polymer as a base polymer is preferable as the pressure-sensitive adhesive from the point of view of clean washing properties of an electric part such as a semiconductor wafer and glass that dislike contamination with ultra pure water and an organic solvent such as alcohol.

Examples of the acrylic polymer include acrylic polymers each comprising, as one or more monomer components, one or more selected from alkyl esters of (meth) acrylic acid (for example, linear and branched alkyl esters thereof each having an alkyl group having 1 to 30 carbon atoms, in particular, 4 to 18 carbon atoms, such as methyl ester, ethyl ester, propyl ester, isopropyl ester, butyl ester, isobutyl ester, s-butyl ester, t-butyl ester, pentyl ester, isopentyl ester, hexyl ester, heptyl ester, octyl ester, 2-ethylhexyl ester, isooctyl ester, nonyl ester, decyl ester, isodecyl ester, undecyl ester, dodecyl ester, tridecyl ester, tetradecyl ester, hexadecyl ester, octadecyl ester, and eicosyl ester thereof) and cycloalkyl esters of (meth)acrylic acid (for example, cyclopentyl ester and cyclohexyl ester thereof). The wording "esters of (meth) acrylic acid" means esters of acrylic acid and/or methacrylic acid. All of the words including "(meth)" in connection with the present invention have an equivalent meaning.

The acrylic polymer may optionally contain a unit corresponding to a different monomer component copolymerizable with the above-mentioned alkyl ester of (meth)acrylic acid or cycloalkyl ester thereof in order to improve the cohesive force, heat resistance or some other property of the polymer. Examples of such a monomer component include carboxyl-containing monomers such as acrylic acid, methacrylic acid, carboxyethyl (meth)acrylate, carboxypentyl (meth) acrylate, itaconic acid, maleic acid, fumaric acid, and crotonic acid; acid anhydride monomers such as maleic anhydride, and itaconic anhydride; hydroxyl-containing monomers such as 2-hydroxyethyl (meth)acrylate, 2-hydroxypropyl (meth) acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, and (4-hydroxylmethylcyclohexyl)methyl (meth)acrylate; sulfonic acid group containing monomers such as styrenesulfonic acid, allylsulfonic acid, 2-(meth)acrylamide-2-methylpropanesulfonic acid, (meth)acrylamidepropanesulfonic acid, sulfopropyl (meth)acrylate, and (meth)acryloyloxynaphthalenesulfonic acid; phosphoric acid group containing monomers such as 2-hydroxyethylacryloyl phosphate; acrylamide; and acrylonitrile. These copolymerizable monomer components may be used alone or in combination of two or more thereof. The amount of the copolymerizable monomer(s) to be used is preferably 40% or less by weight of all the monomer components.

For crosslinking, the acrylic polymer can also contain multifunctional monomers if necessary as the copolymerizable monomer component. Such multifunctional monomers include hexane diol di(meth)acrylate, (poly)ethylene glycol di(meth)acrylate, (poly)propylene glycol di(meth)acrylate, neopentyl glycol di(meth)acrylate, pentaerythritol di(meth) acrylate, trimethylol propane tri(meth)acrylate, pentaerythritol tri(meth)acrylate, dipentaerythritol hexa(meth)acrylate, epoxy (meth)acrylate, polyester (meth)acrylate, urethane (meth)acrylate etc. These multifunctional monomers can also be used as a mixture of one or more thereof. From the viewpoint of adhesiveness etc., the use amount of the multifunctional monomer is preferably 30 wt% or less based on the whole monomer components.

The acrylic polymer can be obtained by polymerizing a single monomer or a mixture of monomers of two types or more. The polymerization can be performed with any of polymerization methods such as solution polymerization, emulsification polymerization, bulk polymerization, and suspension polymerization. The content of a low molecular weight material is preferably small from the point of view of prevention of contamination to a clean adherend. In this respect, the number average molecular weight of the acrylic polymer is preferably about 100,000 or more, and more preferably about 200,000 to 3,000,000, and especially preferably about 300,000 to 1,000,000.

Further, an external crosslinking agent can be suitably adopted to the pressure-sensitive adhesive in order to increase the number average molecular weight of an acrylic polymer that is a base polymer, etc. Specific examples of the external crosslinking method include methods of reacting by adding a so-called crosslinking agents such as a polyisocyanate compound, an epoxy compound, an aziridine compound, and a melamine based crosslinking agent. When the external crosslinking agent is used, the amount to be used can be suitably determined by the balance with the base polymer that is to be crosslinked and by the purpose of use as a pressure-sensitive adhesive. In general, it is preferably mixed at about 5 parts by weight or less, and more preferably 0.1 to 5 parts by weight to 100 parts by weight of the base polymer. Besides the above-described components, an additive such as conventionally known various tackifiers and antioxidants may be used in the pressure-sensitive adhesive depending on necessity.

The pressure sensitive adhesive layer 2 is constituted by containing a radiation curable pressure sensitive adhesive. The radiation curable pressure sensitive adhesive can easily decrease its adhesive strength by increasing the degree of crosslinking by irradiation with radiation such as ultraviolet-ray. By radiating only a part 2a corresponding to the work attaching part of the pressure sensitive adhesive layer 2 shown in Fig. 2, a difference of the adhesive strength to another part 2b can be also provided.

Also, by curing the radiation curable pressure-sensitive adhesive layer 2 together with the thermal bonding sheet 3' shown in Fig. 2, the part 2a where the adhesive strength is significantly reduced can be easily formed. Since the thermal bonding sheet 3' is attached to the part 2a that has been cured and has reduced adhesive strength, the boundary in the pressure-sensitive adhesive layer 2 between the part 2a and the thermal bonding sheet 3' has the property of easily peeling off at the time of pickup. On the other hand, the part that has not been irradiated with radiation has sufficient adhesive strength, and forms the part 2b. Irradiation of the pressure-sensitive adhesive layer can be conducted after dicing and before pickup.

As described above, in the pressure-sensitive adhesive layer 2 of the thermal bonding sheet with dicing tape 10 shown in Fig. 1, the part 2b formed of the uncured radiation curable pressure-sensitive adhesive adheres to the thermal bonding sheet 3, and the holding force at the time of dicing can be secured. In such a way, the radiation curable pressure-sensitive adhesive can support the thermal bonding sheet 3 for fixing the chip-like work (e.g., semiconductor chip) onto an adherend such as a substrate with good balance of adhesion and peeling. In the pressure-sensitive adhesive layer 2 of the thermal bonding sheet with dicing tape 11 shown in Fig. 2, the part 2b can fix the wafer ring.

A radiation curable pressure-sensitive adhesive having an radiation curable functional group such as a carbon-carbon double bond and having adherability can be used without special limitation. Example of the radiation curable pressure-sensitive adhesive include an additive-type radiation curable pressure-sensitive adhesives in which an radiation curable monomer component or oligomer component is mixed into a general pressure-sensitive adhesive such as an acrylic pressure-sensitive adhesive or a rubber-based pressure-sensitive adhesive.

The radiation-curing monomer component to be compounded includes, for example, urethane oligomer, urethane (meth)acrylate, trimethylol propane tri(meth)acrylate, tetramethylol methane tetra(meth)acrylate, pentaerythritol tri(meth)acrylate, pentaerythritol tetra(meth)acrylate, dipentaerythritol monohydroxy penta(meth)acrylate, dipentaerythritol hexa(meth)acrylate, 1,4-butane diol di(meth)acrylate, tetraethylene glycol di(meth)acrylate, 1,6-hexane diol (meth)acrylate, neopentyl glycol di(meth)acrylate etc.; ester acrylate oligomers; and isocyanurates or isocyanurate compounds such as 2-propenyl-3-butenyl cyanurate, tris(2-methacryloxyethyl) isocyanurate etc. The radiation-curing oligomer component includes various acrylate oligomers such as those based on urethane, polyether, polyester, polycarbonate, polybutadiene etc., and their molecular weight is preferably in the range of about 100 to 30000. For the compounded amount of the radiation-curable monomer component or oligomer component, the amount of which the adhesive strength of the pressure-sensitive adhesive layer can be decreased can be determined appropriately depending on the type of the above-described pressure-sensitive adhesive layer. In general, the compounded amount is, for example, 5 to 500 parts by weight relative to 100 parts by weight of the base polymer such as an acrylic polymer constituting the pressure-sensitive adhesive, and preferably about 40 to 150 parts by weight.

Besides the additive-type radiation curable pressure-sensitive adhesive that is explained above, examples of the radiation curable pressure-sensitive adhesive include an internal radiation curable pressure-sensitive adhesive in which a polymer having a carbon-carbon double bond in the polymer side chain, in the main chain, or in the ends of the main chain is used as the base polymer. The internal radiation curable pressure-sensitive adhesive does not have to contain an oligomer component that is a low molecular weight component, etc., or it does not contain much of the component. Therefore, it is preferable because a pressure-sensitive adhesive layer having a stable layer structure can be formed without the oligomer component, etc. shifting in the pressure-sensitive adhesive with the passage of time.

A base polymer having a carbon-carbon double bond and having adherability can be used without limitation. As such base polymer, a polymer having an acrylic polymer as a basic skeleton is preferable. Examples of the basic skeleton of the acrylic polymer include the acrylic polymers shown above.

A method of introducing a carbon-carbon double bond into the acrylic polymer is not especially limited, and various methods can be adopted. However, a molecular design is easy when the carbon-carbon double bond is introduced in the polymer side chain. For example, a method of copolymerizing a monomer having a functional group with an acrylic polymer and then performing condensation or an addition reaction on a compound having a functional group that can react with the functional group of the monomer and having a carbon-carbon double bond while maintaining the radiation curing property of a carbon-carbon double bond.

Examples of the combination of these functional groups include a carboxylic acid group and an epoxy group, a carboxylic acid group and an aziridyl group, and a hydroxyl group and an isocyanate group. Among these combinations of the functional group, the combination of a hydroxyl group and an isocyanate group is preferable because of ease of pursuing the reaction. Further, the functional group may be in any side of the acrylic polymer and the above-describe compounds as long as it is a combination of these functional groups so that the acrylic polymer having a carbon-carbon double bond is produced. However, the case where the acrylic polymer has a hydroxyl group and the above-described compound has an isocyanate group is preferable in the above-described preferable combination. In this case, examples of the isocyanate compound having a carbon-carbon double bond include methacryloylisocyanate, 2-methacryloyloxyethylisocyanate, and m-isopropenyl-$\alpha,\alpha$-dimethylbenzylisocyanate. Further, a polymer in which the hydroxyl group containing the monomers exemplified above and an ether based compound of 2-hydroxyethylvinylether, 4-hydroxybutylvinylether, diethylene glycol monovinylether, etc. are copolymerized can be used as the acrylic polymer.

A base polymer having a carbon-carbon double bond (especially, acrylic polymer) can be used alone as the internal-type radiation curable pressure-sensitive adhesive. However, the above-described radiation curable monomer component or oligomer component can be mixed to an extent that its characteristics do not deteriorate. The amount of the radiation curable oligomer component, etc. is normally in the range of 0 to 30 parts by weight and preferably in the range of 0 to 10 parts by weight to 100 parts by weight of the base polymer.

A photopolymerization initiator is contained in the internal radiation curable pressure sensitive adhesive in the case of curing with radiation such as ultraviolet rays. Examples of the photopolymerization initiator include an $\alpha$-ketol based compound such as 4-(2-hydroxyethoxy)phenyl(2-hydroxy-2-propyl)ketone, $\alpha$-hydroxy-$\alpha$,$\alpha$'-dimethylacetophenone, 2-methyl-2-hydroxypropyophenone, and 1-hydroxycyclohexylphenylketone; an acetophenone based compound such as methoxyacetophenone, 2,2-dimethoxy-2-phenylcetophenone, 2,2-diethoxyacetophenone, and 2-methyl-1-[4-(methylthio)-phenyl]-2-morpholinopropane-1; a benzoinether based compound such as benzoinethylether, benzoinisopropylether, and anisoinmethylether; a ketal based compound such as benzyldimethylketal; an aromatic sulfonylchloride based compound such as 2-naphthalenesulfonylchloride; a photoactive oxime based compound such as 1-phenone-1,1-propanedion-2-(o-ethoxycarbonyl)oxime; a benzophenone based compound such as benzophenone, benzoylbenzoic acid and 3,3'-dimethyl-4-methoxybenzophenone; a thioxanthone based compound such as thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, and 2,4-diisopropylthioxanthone; camphorquinone; halogenated ketone; acylphosphinoxide; acylphosphonate and the like. The compounding amount of the photopolymerization initiator is about 0.05 to 20 parts by weight for example based on 100 parts by weight of the base polymer such as an acryl polymer constituting the pressure sensitive adhesive.

Further, examples of the radiation curable pressure sensitive adhesive include a rubber based pressure sensitive adhesive and acryl-based pressure sensitive adhesive containing an addition polyerizable compound having two or more unsaturated bonds, a photopolymerizable compound such as alkoxysilane having an epoxy group, and a photopolymerization initiator such as a carbonyl compound, an organic sulfur compound, a peroxide, an amine salt-based and an onium salt based compound, which are disclosed in JP-A No. 60-196956.

The radiation curable pressure-sensitive adhesive layer 2 can contain a compound that colors by irradiation as necessary. By containing the compound that colors by irradiation in the pressure-sensitive adhesive layer 2, only the part that is irradiated with radiation can be colored. In other words, the part 2a corresponding to a work attaching part 3a shown in Fig. 1 can be colored. Therefore, it is possible to rapidly determine whether the pressure-sensitive adhesive layer 2 is irradiated with radiation by visual inspection, and the work attaching part 3a is easy to recognize, and bonding of the work is easy. In detecting a semiconductor chip by an optical sensor or the like, the detection accuracy is improved, and a malfunction does not occur at the time of pickup of the semiconductor chip. The compound that colors by irradiation is a compound that is colorless or light-colored before irradiation, but becomes colored by irradiation, and, for example, a leuco dye can be recited. The use rate of the compound that colors by irradiation can be set appropriately.

The thickness of the pressure sensitive adhesive layer 2 is not particularly limited. However, it is preferably about 1 to 50 $\mu$m from the viewpoints of compatibility of chipping prevention of the chip cut face and holding the fixation of the adhesive layer, etc. It is preferably 2 to 30 $\mu$m, and further preferably 5 to 25 $\mu$m.

The dicing tape 11 according to the present embodiment is manufactured for example as follows. First, the base material 1 can be formed with a conventionally known film forming method. Examples of the film forming method include a calendar film forming method, a casting method in an organic solvent, an inflation extrusion method in a closed system, a T die extrusion method, a coextrusion method, and a dry lamination method.

Next, the pressure-sensitive adhesive layer can be formed by coating a pressure-sensitive adhesive composition solution onto a base material to form a coating film, and then drying the coating film under prescribed conditions (and heat-crosslinking depending on necessity). The coating method is not especially limited, and examples thereof include roll coating, screen coating, and gravure coating. As the drying condition, drying is conducted, for example, at a drying temperature of 80 to 150°C for a drying time of 0.5 to 5 minutes. After forming an applied film by applying a pressure-sensitive adhesive composition on a separator, the applied film may be dried in the above drying condition to form the pressure-sensitive adhesive layer 2. Thereafter, the pressure-sensitive adhesive layer 2 is bonded on the base material 1 together with the separator. In this manner, the dicing tape 11 is prepared.

The thermal bonding sheet with dicing tape 10, 12 can be produced in an ordinary method. For example, by bonding the pressure-sensitive adhesive layer 2 of the dicing tape 11 and the thermal bonding sheet 3, it is possible to produce the thermal bonding sheet with dicing tape 10.

In the thermal bonding sheet with dicing tape 10, it is preferred that the thermal bonding sheet 3 is covered with a separator. In one exemplary method, after bonding the dicing tape 11 and the thermal bonding sheet 3, the base separator that is laminated on the thermal bonding sheet 3 is peeled off, and on an exposed surface of the thermal bonding sheet 3 in the thermal bonding sheet with dicing tape 10 after peeling off the base separator, a separator is attached. In other words, it is preferred that the dicing tape 11, the thermal bonding sheet 3, and the separator are laminated in this sequence.

In the above embodiment, the thermal bonding sheet with dicing tape in which the dicing tape and the thermal bonding sheet are laminated was described. However, the thermal bonding sheet of the present invention may be provided in the state that it is not bonded with the dicing tape.

The thermal bonding sheet is preferably a thermal bonding sheet with both-side separators, which is sandwiched between two separators in the form where the dicing tape is not bonded. That is, a thermal bonding sheet with both-side separators in which the first separator, the thermal bonding sheet, and the second separator are laminated in this sequence is preferred.

Fig. 3 is a cross-sectional schematic view showing one embodiment of the thermal bonding sheet with both-side separators.

A thermal bonding sheet with both-side separators 30 shown in Fig. 3 has such a structure that a first separator 32, the thermal bonding sheet 3, and a second separator 34 are laminated in this sequence. As the first separator 32, and the second separator 34, the one that is identical to the base separator can be used.

The thermal bonding sheet may be in such a form that a separator is laminated on only one surface of the thermal bonding sheet in the form where the dicing tape is not bonded.

(Method of manufacturing semiconductor device)

A method of manufacturing a semiconductor device according to the present embodiment includes:

a step of preparing the thermal bonding sheet, and
a thermal bonding step of thermally bonding a semiconductor chip on an adherend via the thermal bonding sheet (hereinafter, also referred to as the first manufacturing method).

The method of manufacturing a semiconductor device according to the present embodiment also includes:

a step of preparing the thermal bonding sheet with dicing tape,
a bonding step of bonding the thermal bonding sheet of the thermal bonding sheet with dicing tape, and a back surface of a semiconductor wafer,
a dicing step of dicing the semiconductor wafer together with the thermal bonding sheet to form a chip-like semiconductor chip,
a pickup step of picking up the semiconductor chip together with the thermal bonding sheet from the thermal bonding sheet with dicing tape, and
a thermal bonding step of thermally bonding the semiconductor chip onto the adherend via the thermal bonding sheet (hereinafter, also referred to as the second manufacturing method).

The method of manufacturing a semiconductor device according to the first manufacturing method is different from the method of manufacturing a semiconductor device according to the second manufacturing method in that the thermal bonding sheet is used alone, as compared with the method of manufacturing a semiconductor device according to the second manufacturing method where the thermal bonding sheet with dicing tape is used, and these methods are common in other points. In the method of manufacturing a semiconductor device according to the first manufacturing method, after preparing the thermal bonding sheet, the step of bonding the thermal bonding sheet with the dicing tape is conducted, and the subsequent steps can be conducted in the same manner as the method of manufacturing a semiconductor device according to the second manufacturing method. Hereinafter, the method of manufacturing a semiconductor device according to the second manufacturing method is described.

In the method of manufacturing a semiconductor device, the thermal bonding sheet with dicing tape 10, 12 is prepared (preparing step). The separator that is optionally provided onto the thermal bonding sheet 3, 3' is appropriately peeled off, and the dicing thermal bonding sheet 10, 11 of the present invention is used as follows. The manufacturing method is explained below referring to Fig. 3 using the case of the thermal bonding sheet with dicing tape 10 as an example.

First, a semiconductor wafer 4 is fixed onto the semiconductor attaching part 3a of the thermal bonding sheet 3 in the thermal bonding sheet with dicing tape 10 by press-bonding and by adhering and holding (mounting step). The present step is performed while pressing with a pressing means such as a press-bonding roll. A temperature upon mounting is not particularly limited, and is preferably in the range of 23 to 90°C.

As a semiconductor wafer 4, the one in which an electrode pad is formed on one side, and a silver thin film is formed on the outermost surface of the other side (hereinafter, also referred to as backside) is preferred. The thickness of the silver thin film can be, for example, 10 nm to 1000 nm. Between the semiconductor wafer 4 and the silver thin film, a titanium thin film may further be formed. The thickness of the titanium thin film can be, for example, 10 nm to 1000 nm. When the silver thin film is formed, it is possible to thermally bond a semiconductor chip 5 and the thermal bonding sheet 3 firmly in the later-described thermal bonding step. Also when the titanium thin film is formed, the reliability of the electrode is improved. The silver thin film, and the titanium thin film can be formed, for example, by vapor deposition.

Next, dicing of the semiconductor wafer 4 is performed (dicing step). With this operation, a semiconductor chip 5 is formed by cutting the semiconductor wafer 4 into a prescribed size to make it into individual pieces. The dicing method is not particularly limited, but is performed following an ordinary method from the circuit face side of the semiconductor wafer 4, for example. Further, a cutting method, so-called full cut, in which cutting-in is performed to the thermal bonding sheet with dicing tape 10, can be adopted in the present step, for example. The dicing apparatus that is used in the present step is not especially limited, and a conventionally known apparatus can be used. Further, because the semiconductor wafer 4 is adhered and fixed by the thermal bonding sheet with dicing tape 10, chip breakage and chip fly can be suppressed, and at the same time, damage of the semiconductor wafer 4 can be suppressed.

Picking up of the semiconductor chip 5 is performed to peel off the semiconductor chip that is adhered and fixed to the thermal bonding sheet with dicing tape 10 (pickup step). The method of picking up is not especially limited, and various conventionally known methods can be adopted. Examples thereof include a method of pushing up an individual semiconductor chip 5 from the thermal bonding sheet with dicing tape 10 side using a needle and picking up the semiconductor chip 5 that is pushed up with a picking up apparatus.

As the pickup condition, a needle pushing up rate is preferably 5 to 100 mm/sec., more preferably 5 to 10 mm/sec. in terms of prevention of chipping.

Here, the pickup is performed after irradiating the pressure-sensitive adhesive layer 2 with the ultraviolet ray if the pressure-sensitive adhesive layer 2 is of an radiation curable. With this operation, the adhesive strength of the pressure-sensitive adhesive layer 2 to the thermal bonding sheet 3 decreases, and the semiconductor chip 5 is easily peeled off. As a result, the pickup becomes possible without damaging the semiconductor chip. The conditions during ultraviolet ray irradiation such as the radiation strength and the radiation time are not especially limited, and may be appropriately set as necessary. Any known light source for irradiation with ultraviolet ray can be used. When the pressure-sensitive adhesive layer is cured in advance by irradiating with ultraviolet rays, and the cured pressure-sensitive adhesive layer and the thermal bonding sheet are bonded, the irradiation with ultraviolet rays here is not required.

Then, the picked up semiconductor chip 5 is die attached (thermally bonded) to an adherend 6 via the thermal bonding sheet 3 (thermal bonding step). Examples of the adherend 6 include a lead frame, a TAB film, a substrate, and a semiconductor chip that is separately produced. The adherend 6 may be a deformable adherend that can be deformed easily or may be a non-deformable adherend such as a semiconductor wafer that is difficult to be deformed.

Metal lead frames such as a Cu lead frame and a 42 Alloy lead frame can be used as the lead frame. As the substrate, a conventionally known one can be used. An organic substrate made of glass epoxy, BT (Bismaleimide-Triazine), polyimide, and the like can be exemplified. Among these, by using a metal lead frame, it is possible to integrate with the metallic fine particles by thermal bonding. As the substrate, an insulating circuit substrate in which a caper circuit board is laminated on an insulating board such as a ceramic plate can be recited. By using an insulating circuit substrate, it is possible to produce, for example, a power semiconductor device that controls or supplies electric power.

In the thermal bonding step, metallic fine particles are sintered by heating, and a thermally decomposable binder is thermally decomposed as necessary. Also, the residual low-boiling-point binder that has not completely volatilized in the drying step is caused to volatilized. The heating temperature can be preferably 180 to 400°C, more preferably 190 to 370°C, further preferably 200 to 350°C. The heating time can be preferably 0.3 to 300 minutes, more preferably 0.5 to 240 minutes, further preferably 1 to 180 minutes. The thermal bonding may be conducted under a pressurized condition. The pressurizing condition is preferably within the range of 1 to 500 kg/cm$^2$, more preferably within the range of 5 to 400 kg/cm$^2$. The thermal bonding under a pressurized condition can be carried out by an apparatus capable of conducting heating and pressurizing simultaneously such as flip chip bonder, for example, Parallel plate pressing is also applicable.

Next, if necessary, the tip of a terminal portion (inner lead) of the adherend 6 is electrically connected to an electrode pad (not shown in the figures) on the semiconductor chip 5 with a bonding wire 7 (wire bonding step). Examples of the bonding wire 7 that can be used include a gold wire, an aluminum wire, and a copper wire. The temperature when performing the wire bonding is in the range of 23 to 300°C and preferably in the range of 23 to 250°C. The heating time is a few seconds to a few minutes. The connection is in a heated state so that the temperature becomes in the above-described range, and it is performed using both the vibration energy due to ultrasonic waves and the compression energy due to the applied pressure.

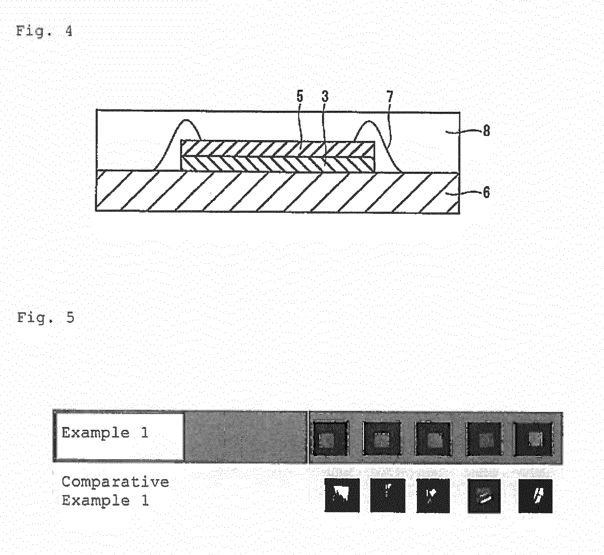

Further, if necessary, the semiconductor chip 5 is sealed with a sealing resin 8 as shown in Fig. 4 (sealing step). The present step is performed to protect the semiconductor chip 5 and the bonding wire 7 that are mounted on the adherend 6. The present step is performed by molding a resin for sealing with a mold. Example of the sealing resin 8 that is used include epoxy resins. The resin sealing is performed normally at a heating temperature of 175°C for 60 to 90 seconds. However, the present invention is not limited to this and it can be performed by curing at 165 to 185°C for a few minutes for example. With this, the sealing resin 8 is cured In the present sealing step, a method of embedding the semiconductor chip 5 into a sheet-like sealing sheet (see, JP-A 2013-7028, for example) can also be employed. Besides the molding of a sealing resin by a die, a gel sealing type in which silicone gel is poured into a case type container is also applicable.

The sealing resin 8 that is not sufficiently cured in the sealing step is cured completely by heating (post curing step) . The heating temperature in the present step differs depending on the type of the sealing resin. However, it is in the range of 165 to 185°C for example, and the heating time is about 0.5 to 8 hours.

The thermal bonding sheet, and the thermal bonding sheet with dicing tape according to the present invention can be favorably used in laminating a plurality of semiconductor chips to achieve three-dimensionally mounting. At this time, a thermal bonding sheet and a spacer may be laminated between semiconductor chips, or not a spacer but only a thermal bonding sheet may be laminated between semiconductor chips, and these can be appropriately changed depending on the manufacturing condition, use application and the like.

Also, the thermal bonding sheet, and the thermal bonding sheet with dicing tape of the present invention can be used for thermally bonding two objects without limited to the application exemplified above.

<<Second embodiment>>

In the thermal bonding sheet according to the first embodiment, while the thickness uniformity is ensured by defining the rates relative to the average thickness of the maximum thickness and the minimum thickness of the precursor layer that is sintered by heating, the thickness uniformity can also be ensured from the view point of the surface roughness in place or in addition to the above. Hereinafter, the thermal bonding sheet according to the second embodiment will be described only for the point that is different from that in the first embodiment.

The thermal bonding sheet according to the present embodiment has a precursor layer that is to become a sintered layer by heating, and

the precursor layer has an average thickness of 5 $\mu$m to 200 $\mu$m, and
a surface roughness Sa of 2 $\mu$m or less measured in a field of view of 200 $\mu$m $\times$ 200 $\mu$m by a confocal microscope.

Since the thermal bonding sheet has a precursor layer that is to become a sintered layer by heating, and a sintered layer is obtained by a heating treatment, high bonding reliability is achieved even when the thermal bonding sheet is used for bonding a power semiconductor device or the like that operates in a high temperature environment. The precursor layer has an average thickness of 5 $\mu$m to 200 $\mu$m, and a surface roughness Sa of 2 $\mu$m or less measured in a field of view of 200 $\mu$m $\times$ 200 $\mu$m by a confocal microscope. As a result, unevenness in the thickness direction is controlled, and the thickness uniformity is satisfied at a high level, so that the bonding irregularity is prevented and high temperature bonding reliability can be improved.

The surface roughness Sa can be 2 $\mu$m or less, preferably 1.5 $\mu$m or less, more preferably 1.0 $\mu$m or less.

EXAMPLES

Hereinafter, the present invention will be specifically described by Examples, however, the present invention is not limited to the following Examples without departing from the scope of the invention.

<Example 1>

In a stirring vessel, as a metallic fine particles-containing paste, 100 parts by weight of ANP-1 (paste in which nano-sized silver fine particles are dispersed) available from NANOPARTICLE LABORATORY CORPORATION. in which an amount of solvent for adjusting the viscosity is appropriately adjusted, as a thermally decomposable binder A, 1 part by weight of acryl resin ("MM-2002-1" (solid at 23°C) available from FUJIKURA KASEI CO., LTD.) and 35 parts by weight of a solvent (methylethyl ketone) were introduced and mixed in a stirring mode for 3 minutes using a hybrid mixer ("HM-500" available from KEYENCE). The obtained vanish was applied on a mold lubricant film ("MRA50" available from Mitsubishi Plastics, Inc.), and the applied film was dried at 150°C for 5 minutes to obtain a thermal bonding sheet having a thickness of 40 $\mu$m.

<Example 2>

Five sheets of the thermal bonding sheet obtained in Example 1 were stacked, and bonded at 80°C with a laminator, to obtain a thermal bonding sheet having a thickness of 200 $\mu$m.

<Example 3>

In a stirring vessel, as a metallic fine particles-containing paste, 100 parts by weight of ANP-1 (paste in which nano-sized silver fine particles are dispersed) available from NANOPARTICLE LABORATORY CORPORATION. in which an amount of solvent for adjusting the viscosity is appropriately adjusted, as a thermally decomposable binder B, 1 part by weight of polypropylene carbonate resin ("QPAC40" (solid at 23°C) available from Empower) and 35 parts by weight of a solvent (methylethyl ketone) were introduced and mixed in a stirring mode for 3 minutes using a hybrid mixer ("HM-500" available from KEYENCE). The obtained vanish was applied on a mold lubricant film ("MRA50" available from Mitsubishi Plastics, Inc.), and the applied film was dried at 150°C for 5 minutes to obtain a thermal bonding sheet having a thickness of 40 $\mu$m.

<Example 4>

Five sheets of the thermal bonding sheet obtained in Example 3 were stacked, and bonded at 80°C with a laminator, to obtain a thermal bonding sheet having a thickness of 200 $\mu$m.

<Comparative Example 1>

The same paste containing metallic fine particles as in Example 1 was used.

<<Evaluation>>

Samples of Examples and Comparative Examples were evaluated for the following items. The respective results are shown in Table 1.

(Thickness evaluation (thermal bonding sheet))

As for the thermal bonding sheets (hereinafter, also simply referred to as "sheet") of Examples 1 to 4 and Comparative Example 2, a sheet of 1 cm $\times$ 10 cm was attached on the backside of a backside metal (Ti/Ag) silicon wafer (10 cm $\times$ 10 cm). Using a confocal microscope ("H300" available from LaserTec Corporation), noncontact measurement under the following condition was conducted for the back surface of the silicon wafer (silicon wafer part and sheet part) on which the sheet is attached, and height was determined.

<Noncontact measurement condition>

Objective lens: 10-fold
Scan time: 60 seconds
Resolving power: 0.03 $\mu$m

By subtracting silicon wafer height h2 from sheet height h1, sheet thickness Ts (= h1 - h2) was determined. Regarding the measurement site, an area of 1 cm $\times$ 10 cm was equally divided in 10 areas, and measurement was conducted at a center point of each area of 1 cm $\times$ 1 cm, totally at 10 points. An average of the 10 points was determined as an average thickness ($\mu$m), and when the maximum value (maximum thickness) and the minimum value (minimum thickness) fell within the range of $\pm$20% of the average thickness, the evaluation was "$\bigcirc$", and when they did not fall within the range of $\pm$20%, the evaluation was "$\times$". The rate of deviation of the maximum thickness or the minimum thickness from the average thickness was determined as a deviation rate (%).

(Evaluation of thickness (metallic fine particles-containing paste))

Regarding the metallic fine particles-containing paste (hereinafter, also simply referred to as "paste") of Comparative Example 1, two pressure-sensitive adhesive tapes having a length of 12 cm were attached at an interval of 1 cm on the backside of the backside metal (Ti/Ag) silicon wafer (No. 31B, width 20 mm, total thickness 0.05 mm (= 50 $\mu$m)). In a silicon wafer part exposed from between the pressure-sensitive adhesive tapes, a paste was applied, and dried at 130°C for 1 minute to form a dried paste film. Then, after peeling off the pressure-sensitive adhesive tapes, for the back surface of the silicon wafer on which the dried paste film is formed (silicon wafer part and dried paste film part), noncontact measurement was conducted using a confocal microscope ("H300" available from LaserTec Corporation) in the same condition with that in the case of the sheet, and height was determined.

By subtracting silicon wafer height h2' from dried paste film height h1', dried paste film thickness Tp (= h1' - h2') was determined. Regarding the measurement site, an area of 1 cm $\times$ 12 cm was equally divided in 12 areas, measurement was conducted at a center point of each area of 1 cm $\times$ 1 cm except the areas of 1 cm $\times$ 1 cm on both ends, totally at 10 points. An average of the 10 points was determined as an average thickness ($\mu$m), and when the maximum value (maximum thickness) and the minimum value (minimum thickness) fell within the range of $\pm20\%$ of the average thickness, the evaluation was "○", and when they did not fall within the range of $\pm20\%$, the evaluation was "×". The rate of deviation of the maximum thickness or the minimum thickness from the average thickness was determined as a deviation rate (%).

(Evaluation of surface roughness Sa (sheet))

On the backside of a backside metal (Ti/Ag) silicon wafer (5 cm $\times$ 5 cm), a sheet in a size of 1 cm square or larger was attached with a laminator at 80°C. Using a confocal microscope ("H300" available from LaserTec Corporation), noncontact measurement was conducted, and surface roughness Sa was determined.

<Noncontact measurement condition>

Objective lens: 10-fold
Scan time: 60 seconds
Resolving power: 0.03 $\mu$m

For an area of 200 $\mu$m $\times$ 200 $\mu$m in the center part of the sheet as a measuring field of view, the surface roughness Sa in that area was measured. When the surface roughness Sa is 2 $\mu$m or less, the evaluation was "O", and when the surface roughness Sa is more than 2 $\mu$m, the evaluation was "×".

(Evaluation of surface roughness Sa (paste))

On the backside of a backside metal (Ti/Ag) silicon wafer (5 cm $\times$ 5 cm), a paste was applied in a size of 1 cm square or larger so that the thickness after drying was 50 $\mu$m. An excess solvent was removed by drying at 130°C for 1 minute, to form a dried paste film. For the dried paste film surface, noncontact measurement was conducted using a confocal microscope ("H300" available from LaserTec Corporation) in the same condition as in the case of the sheet, and surface roughness Sa was determined.
For an area of 200 $\mu$m $\times$ 200 $\mu$m in the center part of the sheet as a measuring field of view, the surface roughness Sa in that area was measured. When the surface roughness Sa is 2 $\mu$m or less, the evaluation was "○", and when the surface roughness Sa is more than 2 $\mu$m, the evaluation was "x".

(Evaluation of bonding irregularity (sheet))

On the entire back surface of a backside metal (Ti/Ag) silicon chip of 5 mm $\times$ 5 mm, a sheet was attached at 80°C, and the result chip with sheet was placed on a silver-plated copper plate (20 mm $\times$ 20 mm, thickness 3 mm). The sheet was heated at 300°C for 2.5 minutes using a sintering device ("HTM-3000" available from Hakuto Co., Ltd.) while the pressure loading of 10 MPa was maintained to give a sintered layer, and thus the chip and the silver-plated copper plate were bonded via the sintered layer. The bonded five samples were observed in a reflection mode (transducer type: PQ-50-13: WD, frequency: 50 MHz) of SAT (ultrasonic imaging device, "FineSAT II" available from Hitachi Construction Machinery Fine Tech) to investigate the presence or absence of peeling between the chip and the silver-plated copper plate. For each of the five samples, the rate of the area of the peeling part, relative to the entire bonding surface was determined, and an average was determined as an average peeling area rate (%). When the average peeling area rate was 10% or less, the evaluation was "○", and the average peeling area rate was more than 10%, the evaluation was "×".

(Evaluation of bonding irregularity (paste))

On the entire back surface of a backside metal (Ti/Ag) silicon chip of 5 mm $\times$ 5 mm, a paste was applied so that the thickness was 50 $\mu$m. An excess solvent was removed by drying at 130°C for 1 minute to form a dried paste film. The chip with dried paste film was placed on a silver-plated copper plate (20 mm $\times$ 20 mm, thickness 3 mm). The chip and the silver-plated copper plate were bonded via a dried paste film using a sintering device ("HTM-3000" available from Hakuto Co., Ltd.) at 300°C for 2.5 minutes while the pressure loading of 10 MPa was maintained to give a sintered layer to provide a sample for evaluation. The bonded five samples were observed in a reflection mode (transducer type: PQ-50-13: WD, frequency: 50 MHz) of SAT (ultrasonic imaging device, "FineSAT II" available from Hitachi Construction Machinery Fine Tech) to investigate the presence or absence of peeling between the chip and the silver-plated copper plate. For each of the five samples, the rate of the area of the peeling part, relative to the entire bonding surface was determined, and an average was determined as an average peeling area rate (%). When the average peeling area rate was 10% or less, the evaluation was "○", and the average peeling area rate was more than 10%, the evaluation was "×".

Fig. 5 shows SAT observation images of samples prepared by using the sheet of Example 1 and the paste of Comparative Example 1. The white part in the image is the peeling part.

(Evaluation of reliability - Residual bonding area rate)

Samples for evaluation according to Examples and Comparative Examples were prepared in the same method as in the evaluation of bonding irregularity described above.

Then, each sample for evaluation was put into a thermal shock tester (TSE-103ES, available from ESPEC CORP.), and 100 cycles of thermal shock of -40°C to 200°C were given (the temperature rising and dropping time between -40°C and 200°C was about 10 minutes). At this time, the sample was kept at -40°C and 200°C for 15 minutes, respectively.

After 100 cycles, imaging was conducted to observe the part where the silicon chip and the copper plate are bonded by the sintered layer using SAT (ultrasonic imaging device, "FineSAT II" available from Hitachi Construction Machinery Fine Tech). The transducer (probe) used here was PQ-50-13: WD [frequency: 50 MHz].

The area of the part where bonding remains (residual area) in the obtained image was determined, and a rate of the residual area relative to the entire area of the bonding surface (residual bonding area rate) was calculated. When the residual bonding area rate was 50% or more, the evaluation was "○", and when the residual bonding area rate was less than 50%, the evaluation was "×". Likewise the SAT image observation in evaluation of bonding irregularity, the white part in the image is the peeling part (not shown).

(Evaluation of weight reduction rate (sheet))

From the prepared thermal bonding sheet, a piece of 5 mm × 5 mm was cut out to have a weight of about 10 mg and given as a measurement sample. For this measurement sample, differential thermogravimetric measurement was carried out at a temperature rising speed of 10°C /min from 23°C to 400°C in an ambient atmosphere, and weight $W_{23}$ of the thermal bonding sheet at 23°C, and weight $W_{400}$ of the thermal bonding sheet at 400°C were read out. When the weight reduction rate $\Delta W$ fell within the range of -9% to -3%, the evaluation was "○", and when the weight reduction rate $\Delta W$ was less than -9% or more than -3%, the evaluation was "×".

$$\Delta W (\%) = \{(W_{400} - W_{23}) / W_{23}\} \times 100$$

(Evaluation of weight reduction rate (paste))

The same procedure as in measurement of the weight reduction rate of sheet was employed except that as a measurement sample, an applied liquid film having a thickness of 40 $\mu$m formed by applying a metallic fine particles-containing paste on a mold lubricant film ("MRA50" available from Mitsubishi Plastics, Inc.) was used.

[Table 1]

| | | Example 1 | Example 2 | Example 3 | Example 4 | Comparative Example 1 |
|---|---|---|---|---|---|---|
| Metallic fine particles-containing paste | ANP-1 | 100 | 100 | 100 | 100 | 100 |
| Thermal decomposable binder A | MM2002-1 | 1 | 1 | - | - | - |
| Thermal decomposable binder B | QPAC40 | - | - | 1 | 1 | - |
| Polyimide resin | Polyimide | - | - | - | - | - |
| Average thickness of thermal bonding sheet [$\mu$m] | | 40 | 200 | 40 | 200 | 50 |
| Evaluation of evaluation (): Deviation rate of maximum thickness or minimum thickness from average thickness | | ○ (8%) | ○ (15%) | ○ (5%) | ○ (18%) | × (40%) |

(continued)

|  | Example 1 | Example 2 | Example 3 | Example 4 | Comparative Example 1 |
|---|---|---|---|---|---|
| Evaluation of surface roughness Sa (): Measured surface roughness Sa | O (0.15 μm) | ○ (0.35 μm) | ○ (0.17 μm) | ○ (0.29 μm) | × (3.3 μm) |
| Evaluation of bonding irregularity (): Average peeling area rate | ○ (0%) | ○ (0%) | O (0%) | ○ (0%) | × (43%) |
| Evaluation of reliability (): Residual bonding area rate after thermal cycles | ○ (74%) | ○ (74%) | ○ (83%) | ○ (83%) | × (35%) |
| Evaluation of weight reduction rate (): Weight reduction rate | ○ (-5.0%) | ○ (-5.0%) | ○ (-5.7%) | ○ (-5.7%) | × (-10.3%) |

In Examples 1 to 4, both the thickness evaluation and surface roughness Sa were excellent, and accordingly, both the evaluation of bonding irregularity and the evaluation of reliability were excellent. Also the evaluation of weight reduction rate was excellent, and it is estimated that organic components are substantially removed by heating to 400°C assuming the sintering step. On the other hand, in Comparative Example 1, both the evaluation of thickness and the evaluation of surface roughness Sa were out of the range, and accordingly, both the evaluation of bonding irregularity and the evaluation of reliability showed were poor. It is inferable that the increase peeing area caused by thickness nonuniformity is a major cause. It is considered that also the large weight reduction rate influences on deterioration in uniformity of thickness.

DESCRIPTION OF REFERENCE SIGNS

1: Base material
2: Pressure-sensitive adhesive layer
3, 3': Thermal bonding sheet
4: Semiconductor wafer
5: Semiconductor chip
6: Adherend
7: Bonding wire
8: Sealing resin
10, 12: Thermal bonding sheet with dicing tape
11: Dicing tape
30: Thermal bonding sheet with both-side separators
31: Precursor layer that is to become a sintered layer by heating
32: First separator
34: Second separator

**Claims**

1.   A thermal bonding sheet, comprising a precursor layer that is to become a sintered layer by heating,
the precursor layer having an average thickness of 5 μm to 200 μm, wherein the average thickness is determined using the following method:

a sheet of 1 cm × 10 cm was attached on the backside of a backside metal (Ti/Ag) silicon wafer (10 cm × 10 cm); using a confocal microscope, noncontact measurement under the following condition was conducted for the back surface of the silicon wafer on which the sheet is attached, and height was determined:
<Noncontact measurement condition>
Objective lens: 10-fold
Scan time: 60 seconds
Resolving power: 0.03 μm;
by subtracting the silicon wafer height $h2$ from sheet height $h1$, sheet thickness Ts (= $h1$ - $h2$) was determined; an area of 1 cm × 10 cm was equally divided in 10 areas, and measurement was conducted at a center point of each area of 1 cm × 1 cm, totally at 10 points; an average of the 10 points was determined as an average thickness; wherein the precursor layer contains a thermally decomposable binder that is solid at 23°C, wherein the thermally decomposable binder is an acryl resin or a polycarbonate;

wherein the precursor layer contains a low-boiling-point binder which is liquid at 23°C, wherein the low-boiling-point binder is selected from the group consisting of monohydric alcohols, polyhydric alcohols, ethers, ethylene glycol ethyl ether acetate, ethylene glycol butyl ether acetate, diethylene glycol ethyl ether acetate, diethylene glycol butyl ether acetate, dipropylene glycol methyl ether acetate, and combinations thereof; and

wherein the precursor layer contains from 60 to 98% by weight of metallic fine particles selected from the group consisting of silver, copper, silver oxide and copper oxide, wherein the metallic fine particles have an average particle size of from 0.0005 to 30 μm, determined by observing using a scanning electron microscope; the precursor layer having a maximum thickness and a minimum thickness falling within a range of ±20% of the average thickness.

2. The thermal bonding sheet according to claim 1,
the precursor layer having an average thickness of 5 μm to 200 μm and a surface roughness Sa of 2 μm or less measured in a field of view of 200 μm × 200 μm by a confocal microscope, wherein the surface roughness is determined by the following method:

on the backside of a backside metal, Ti/Ag, silicon wafer of 5 cm × 5 cm size, a sheet in a size of 1 cm square or larger was attached with a laminator at 80°C; using a confocal microscope, noncontact measurement was conducted, and surface roughness Sa was determined;
<Noncontact measurement condition>
Objective lens: 10-fold
Scan time: 60 seconds
Resolving power: 0.03 μm;
for an area of 200 μm × 200 μm in the center part of the sheet as a measuring field of view, the surface roughness Sa in that area was measured.

3. The thermal bonding sheet according to claim 1 or 2, wherein when differential thermogravimetric measurement is carried out at a temperature rising speed of 10°C/min from 23°C to 400°C in an ambient atmosphere, a weight reduction rate $\Delta W$ obtained by the following formula is -9% to -3%:

$$\Delta W(\%) = \{(W_{400}-W_{23})/W_{23}\} \times 100$$

wherein, $W_{23}$ represents weight of the thermal bonding sheet at 23°C, and $W_{400}$ represents weight of the thermal bonding sheet at 400°C, and
wherein the evaluation of weight reduction rate is as follows:
from the prepared thermal bonding sheet, a piece of 5 mm × 5 mm was cut out to have a weight of about 10 mg and given as a measurement sample; for this measurement sample, differential thermogravimetric measurement was carried out at a temperature rising speed of 10°C /min from 23°C to 400°C in an ambient atmosphere, and weight $W_{23}$ of the thermal bonding sheet at 23°C, and weight $W_{400}$ of the thermal bonding sheet at 400°C were read out.

4. A thermal bonding sheet with dicing tape, comprising:

a dicing tape, and
the thermal bonding sheet according to any one of claims 1 to 3 laminated on the dicing tape.

**Patentansprüche**

1. Eine thermische Verbindungsfolie, die eine Vorläuferschicht umfasst, die durch Erhitzen zu einer gesinterten Schicht wird,

wobei die Vorläuferschicht eine durchschnittliche Dicke von 5 μm bis 200 μm aufweist, wobei die durchschnittliche Dicke mit dem folgenden Verfahren bestimmt wird:
eine Folie von 1 cm × 10 cm wird auf der Rückseite eines rückseitigen Metall(Ti/Ag)-Siliziumwafers (10 cm × 10 cm) angebracht; unter Verwendung eines konfokalen Mikroskops wird eine berührungslose Messung unter den folgenden Bedingungen für die Rückseite des Siliziumwafers durchgeführt, auf dem die Folie angebracht ist, und die Höhe wurde bestimmt:

<Bedingungen der berührungslosen Messung>
Objektivlinse: 10-fach
Scanzeit: 60 Sekunden
Auflösungsvermögen: 0,03 μm;
durch Subtrahieren der Siliziumwaferhöhe h2 von der Folienhöhe h1 wird die Foliendicke Ts (= h1 - h2) bestimmt; eine Fläche von 1 cm × 10 cm wird gleichmäßig in 10 Flächen aufgeteilt, und die Messung wird an einem Mittelpunkt jeder Fläche von 1 cm × 1 cm insgesamt an 10 Punkten durchgeführt; ein Durchschnitt der 10 Punkte wird als Durchschnittsdicke bestimmt;
wobei die Vorläuferschicht ein thermisch zersetzbares Bindemittel enthält, das bei 23 °C fest ist, wobei das thermisch zersetzbare Bindemittel ein Acrylharz oder ein Polycarbonat ist;
wobei die Vorläuferschicht ein niedrigsiedendes Bindemittel enthält, das bei 23 °C flüssig ist, wobei das niedrigsiedende Bindemittel ausgewählt ist aus der Gruppe bestehend aus einwertigen Alkoholen, mehrwertigen Alkoholen, Ethern, Ethylenglykolethyletheracetat, Ethylenglykolbutyletheracetat, Diethylenglykolethyletheracetat, Diethylenglykolbutyletheracetat, Dipropylenglykolmethyletheracetat und Kombinationen davon;
wobei die Vorläuferschicht 60 bis 98 Gewichtsprozent metallische Feinpartikel enthält, die aus der Gruppe bestehend aus Silber, Kupfer, Silberoxid und Kupferoxid ausgewählt sind, wobei die metallischen Feinpartikel eine durchschnittliche Partikelgröße von 0,0005 bis 30 μm aufweisen, die durch Beobachtung unter einem Rasterelektronenmikroskop bestimmt wird;
wobei die Vorläuferschicht eine maximale Dicke und eine minimale Dicke aufweist, die in einem Bereich von ±20 % der durchschnittlichen Dicke liegen.

2. Die thermische Verbindungsfolie gemäß Anspruch 1, wobei die Vorläuferschicht eine durchschnittliche Dicke von 5 μm bis 200 μm aufweist und eine in einem Sichtfeld von 200 μm × 200 μm mit einem konfokalen Mikroskop gemessene Oberflächenrauheit Sa von 2 μm oder weniger, wobei die Oberflächenrauheit mit dem folgenden Verfahren bestimmt wird:

auf der Rückseite eines rückseitigen Ti/Ag-Metall-Siliziumwafers mit einer Größe von 5 cm × 5 cm wird eine Folie mit einer Größe von 1 cm² oder mehr mit einem Laminator bei 80°C angebracht; unter Verwendung eines konfokalen Mikroskops wird eine berührungslose Messung durchgeführt, und die Oberflächenrauheit Sa wurde bestimmt;
<Bedingungen der berührungslosen Messung>
Objektivlinse: 10-fach
Scanzeit: 60 Sekunden
Auflösungsvermögen: 0,03 μm;
für einen Bereich von 200 μm × 200 μm im Mittelteil der Folie als Messsichtfeld wird die Oberflächenrauheit Sa in diesem Bereich gemessen.

3. Die thermische Verbindungsfolie gemäß Anspruch 1 oder 2, wobei bei einer differentiellen thermogravimetrischen Messung bei einer Temperaturanstiegsgeschwindigkeit von 10°C/min von 23 °C auf 400 °C in einer Umgebungsatmosphäre die Gewichtsreduktionsrate $\Delta W$, die durch die nachstehende Formel erhalten wird, im Bereich von -9 % bis -3 % liegt:

$$\Delta W(\%) = \{(W_{400}-W_{23})/W_{23}\} \times 100$$

wobei $W_{23}$ das Gewicht der thermischen Verbindungsfolie bei 23°C darstellt und $W_{400}$ das Gewicht der thermischen Verbindungsfolie bei 400°C darstellt, und
wobei die Bewertung der Gewichtsreduzierungsrate wie folgt erfolgt:
aus der vorbereiteten thermischen Verbindungsfolie wird ein Stück der Größe 5 mm × 5 mm mit einem Gewicht von etwa 10 mg ausgeschnitten und als Messprobe verwendet; für diese Messprobe wird eine differentielle thermogravimetrische Messung bei einer Temperaturanstiegsgeschwindigkeit von 10 °C/min von 23 °C auf 400 °C in einer Umgebungsatmosphäre durchgeführt und das Gewicht $W_{23}$ des thermischen Klebeblatts bei 23 °C und das Gewicht $W_{400}$ des thermischen Klebeblatts bei 400 °C wird abgelesen.

**4.** Eine thermische Verbindungsfolie mit Dicing-Band, umfassend:

ein Dicing-Band und
die thermische Verbindungsfolie gemäß einem der Ansprüche 1 bis 3, die auf das Dicing-Band laminiert ist.

**Revendications**

**1.** Feuille de liaison thermique, comprenant une couche de précurseur destinée à devenir une couche frittée par chauffage,
la couche de précurseur présentant une épaisseur moyenne de 5 μm à 200 μm, dans laquelle l'épaisseur moyenne est déterminée en utilisant le procédé suivant :
une feuille de 1 cm × 10 cm a été liée sur la face arrière d'une plaquette de silicium à métal/métaux (Ti/Ag) sur face arrière (10 cm × 10 cm) ; en utilisant un microscope confocal, une mesure sans contact sous la condition suivante a été mise en œuvre pour la surface arrière de la plaquette de silicium sur laquelle la feuille est liée, et une hauteur a été déterminée :

<Condition de mesure sans contact>
Objectif : × 10
Temps de balayage : 60 secondes
Puissance de résolution : 0,03 μm ;
en soustrayant la hauteur h2 de la plaquette de silicium de la hauteur h1 de la feuille, l'épaisseur de la feuille Ts (= h1 - h2) a été déterminée ; une surface de 1 cm × 10 cm a été divisée de façon égale en 10 surfaces, et une mesure a été mise en œuvre au niveau d'un point central de chaque surface de 1 cm × 1 cm, soit au total en 10 points ; et une moyenne des 10 points a été déterminée en tant qu'épaisseur moyenne ;
dans laquelle la couche de précurseur contient un agent de liaison pouvant être décomposé thermiquement qui est solide à 23 °C, et dans laquelle l'agent de liaison pouvant être décomposé thermiquement est une résine acrylique ou un polycarbonate ;
dans laquelle la couche de précurseur contient un agent de liaison à point d'ébullition faible qui est liquide à 23 °C, et dans laquelle l'agent de liaison à point d'ébullition faible est sélectionné parmi le groupe constitué par les alcools monohydriques, les alcools polyhydriques, les éthers, l'acétate d'éther éthylique d'éthylène glycol, l'acétate d'éther butylique d'éthylène glycol, l'acétate d'éther éthylique de diéthylène glycol, l'acétate d'éther butylique de diéthylène glycol, l'acétate d'éther méthylique de dipropylène glycol et des combinaisons de ceux-ci ; et
dans laquelle la couche de précurseur contient de 60 % à 98 % en poids de particules fines métalliques sélectionnées parmi le groupe constitué par l'argent, le cuivre, l'oxyde d'argent et l'oxyde de cuivre, et dans laquelle les particules fines métalliques présentent une dimension de particule moyenne de 0,0005 μm à 30 μm, déterminée par observation en utilisant un microscope électronique à balayage ;
la couche de précurseur présentant une épaisseur maximum et une épaisseur minimum tombant à l'intérieur d'une plage de ± 20 % de l'épaisseur moyenne.

**2.** Feuille de liaison thermique selon la revendication 1, la couche de précurseur présentant une épaisseur moyenne de 5 μm à 200 μm et une rugosité de surface Sa de 2 μm ou moins, lesquelles épaisseur moyenne et rugosité de surface sont mesurées dans un champ de vision de 200 μm × 200 μm par un microscope confocal, dans laquelle la rugosité de surface est déterminée au moyen du procédé suivant :

sur la face arrière d'une plaquette de silicium à métal/métaux, Ti/Ag, sur face arrière d'une dimension de 5 cm × 5 cm, une feuille d'une dimension de 1 cm² ou plus a été liée à l'aide d'un dispositif de stratification à 80 °C ; en utilisant un microscope confocal, une mesure sans contact a été mise en œuvre, et une rugosité de surface Sa a été déterminée ;
<Condition de mesure sans contact>
Objectif : × 10
Temps de balayage : 60 secondes
Puissance de résolution : 0,03 μm ;
pour une surface de 200 μm × 200 μm dans la partie centrale de la feuille en tant que champ de vision de mesure, la rugosité de surface Sa dans cette surface a été mesurée.

**3.** Feuille de liaison thermique selon la revendication 1 ou 2, dans laquelle, lorsqu'une mesure thermogravimétrique différentielle est mise en œuvre à une vitesse d'augmentation de la température de 10 °C/minute de 23 °C à 400 °C dans une atmosphère ambiante, un taux de réduction de poids ΔW obtenu au moyen de la formule suivante est compris entre -9 % et -3 % :

$$\Delta W \ (\%) = \{(W_{400} - W_{23})/W_{23}\} \times 100$$

formule dans laquelle :

$W_{23}$ représente le poids de la feuille de liaison thermique à 23 °C et $W_{400}$ représente le poids de la feuille de liaison thermique à 400 °C ; et
dans laquelle l'évaluation du taux de réduction de poids est comme suit :
à partir de la feuille de liaison thermique préparée, une pièce de 5 mm × 5 mm a été découpée de telle sorte qu'elle présente un poids d'environ 10 mg et a été fournie en tant qu'échantillon de mesure ; pour cet échantillon de mesure, une mesure thermogravimétrique différentielle a été mise en œuvre à une vitesse d'augmentation de la température de 10 °C/minute de 23 °C à 400 °C dans une atmosphère ambiante, et le poids $W_{23}$ de la feuille de liaison thermique à 23 °C et le poids $W_{400}$ de la feuille de liaison thermique à 400 °C ont été lus.

4. Feuille de liaison thermique munie d'un ruban de découpage, comprenant :

un ruban de découpage ; et
la feuille de liaison thermique selon l'une quelconque des revendications 1 à 3 stratifiée sur le ruban de découpage.

Fig. 1

Fig. 2

Fig. 3

Fig. 4

Fig. 5

**EP 3 358 606 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014111800 A
- JP 60196956 A
- JP 2013007028 A

**Non-patent literature cited in the description**

- **KIM S. SIOW**. Mechanical propertiers of nano-silver joints as die attach materials. *Journal of Alloys and Compounds*, 28 October 2011, vol. 514, 6-19